# EUROPEAN PATENT APPLICATION

(11) **EP 4 718 498 A1**
(43) Date of publication of application: **01.04.2026**
(21) Application number: 25164720.2
(22) Date of filing: 19.03.2025
(51) Int. Cl.: H01L 21/02, H10D 62/854, H10D 30/47

(54) **SEMICONDUCTOR STRUCTURE AND MANUFACTURING METHOD THEREOF**

(30) Priority: 25.09.2024 TW 113136409
(71) Applicant: Taiwan-Asia Semiconductor Corporation, Hsinchu City 30078 (TW)
(72) Inventor: Li, Chun-Chieh, 30078 Hsinchu City (TW)
(74) Representative: Michalski Hüttermann & Partner Patentanwälte mbB

(57) **Abstract**

A semiconductor structure and the manufacturing method thereof are provided. The semiconductor structure comprises a silicon substrate (10), a nitride buffer composite layer (20), an active layer and a silicon barrier composite layer (30). The nitride buffer composite layer is disposed above the silicon substrate, the active layer is disposed above the nitride buffer composite layer, and the silicon barrier composite layer is disposed within the nitride buffer composite layer to substantially block the diffusion of silicon impurities from the silicon substrate to reduce leakage current.

## Description

### BACKGROUND OF THE INVENTION

### Field of the Invention

The present invention relates to a semiconductor structure, and in particular to a semiconductor structure with reducing the diffusion of silicon impurities from a silicon substrate.

### Descriptions of the Related Art

In high electron mobility transistors (HEMTs) and GaN-on-Silicon devices, the diffusion of silicon impurities from the silicon substrate may impact device performance in the following ways. First, regarding lattice defects, if silicon impurities from the substrate diffuse into the GaN layer, they may induce lattice defects, which can increase leakage current, reduce the device's breakdown voltage, and affect its reliability. Second, regarding reduction in electron mobility, impurity diffusion can lead to increased carrier scattering, thereby reducing electron mobility in the channel. This degradation negatively impacts the high-frequency performance and output power of HEMT devices. Third, regarding formation of parasitic conductive layers, the diffusion of silicon impurities may result in the formation of parasitic conductive layers within the GaN layer or buffer layer, leading to increased leakage current and reduced device efficiency. Forth, regarding gate voltage drift, the diffusion of silicon impurities can cause voltage drift between the gate and source, affecting gate control and resulting in device instability. Therefore, mitigating the adverse effects of silicon impurity diffusion from the silicon substrate is a critical issue that needs to be addressed.

### SUMMARY OF THE INVENTION

The main objective of the present invention is to provide an innovative semiconductor structure and its manufacturing method. By reducing the diffusion of silicon impurities volatilized from the silicon substrate into the upper insulating high-resistance epitaxial layer, the invention aims to increase the breakdown voltage of the device and minimize leakage current paths.

To achieve the above objective, the present invention discloses a semiconductor structure which comprises a silicon substrate, a nitride buffer composite layer, an active layer and a silicon barrier composite layer. The nitride buffer composite layer is disposed above the silicon substrate, the active layer is disposed above the nitride buffer composite layer, and the silicon barrier composite layer is interposed within the nitride buffer composite layer to substantially block the diffusion of silicon impurities from the silicon substrate to reduce leakage current.

In one embodiment of a semiconductor structure of the present invention, the silicon barrier composite layer comprises a plurality of aluminum-containing nitride layers, each of the aluminum-containing nitride layers has a carbon doping concentration, and as the aluminum-containing nitride layers approach the active layer, the carbon doping concentration increases.

In one embodiment of a semiconductor structure of the present invention, each of the aluminum-containing nitride layers is one of an aluminum gallium nitride layer (AlₓGa₍₁₋ₓ)N, 0<x<1), an aluminum indium nitride layer (AlₓIn₍₁₋ₓ₎N, 0<x<1), and an aluminum gallium indium nitride layer (AlₓGa_{y}In_{(1-x-y)}N, 0<x<1, 0<x+y<1).

In one embodiment of a semiconductor structure of the present invention, each of the aluminum-containing nitride layers comprises an aluminum content, and as the aluminum-containing nitride layers approach the active layer, the aluminum content of each of the aluminum-containing nitride layers increases.

In one embodiment of a semiconductor structure of the present invention, each of the aluminum-containing nitride layers comprises an aluminum content, and as the aluminum-containing nitride layers approach the active layer, the aluminum content of each of the aluminum-containing nitride layers decreases.

In one embodiment of a semiconductor structure of the present invention, the carbon doping concentration of each of the aluminum-containing nitride layers increases from 1E17~1E19/cm³ as the aluminum-containing nitride layers approach the active layer.

In one embodiment of a semiconductor structure of the present invention, a thickness of each of the aluminum-containing nitride layers is less than 500 nanometers (nm) .

In one embodiment of a semiconductor structure of the present invention, the silicon barrier composite layer comprises a plurality of aluminum-containing nitride layers, each of the aluminum-containing nitride layers has an iron doping concentration, and as the aluminum-containing nitride layers approach the active layer, the iron doping concentration increases.

In one embodiment of a semiconductor structure of the present invention, the nitride buffer composite layer comprises a first aluminum nitride buffer layer and a second aluminum nitride buffer layer, and the first aluminum nitride buffer layer is disposed above the silicon substrate.

In one embodiment of a semiconductor structure of the present invention, the active layer disposed above the nitride buffer composite layer sequentially comprises a carbon doped gallium nitride layer, a gallium nitride channel layer, an aluminum gallium nitride buffer layer and an undoped gallium nitride cladding layer.

To achieve the above objective, the present invention discloses a manufacturing method of a semiconductor structure comprising the following steps: providing a silicon substrate, providing a nitride buffer composite layer disposed above the silicon substrate, providing an active layer disposed above the nitride buffer composite layer, and providing a silicon barrier composite layer interposed within the nitride buffer composite layer to substantially block the diffusion of silicon impurities from the silicon substrate to reduce leakage current.

In one embodiment of a manufacturing method of a semiconductor structure of the present invention, the step of providing a silicon barrier composite layer is to provide a plurality of aluminum-containing nitride layers and to carbon dope each of the aluminum-containing nitride layers, and as the aluminum-containing nitride layers approach the active layer, a carbon doping concentration of each of the aluminum-containing nitride layers increases.

In one embodiment of a manufacturing method of a semiconductor structure of the present invention, the step of carbon doping uses one of methane (CH₄), ethylene (C₂H₄), and pentane (C₅H₁₂) as a doping gas for doping, natural doping within a chamber and diffusing.

In one embodiment of a manufacturing method of a semiconductor structure of the present invention, the step of providing a plurality of aluminum-containing nitride layers is made by metal organic vapor deposition (MOCVD) process or molecular beam epitaxy (MBE) process using materials including trimethylgallium (TMGa), triethylgallium (TEGa), trimethylaluminum (TMAl), trimethylindium (TMIn) and ammonia (NH₃).

In one embodiment of a manufacturing method of a semiconductor structure of the present invention, each of the aluminum-containing nitride layers is one of an aluminum gallium nitride layer (AlₓGa₍₁₋ₓ₎N, 0<x<1), an aluminum indium nitride layer (AlₓIn₍₁₋ₓ₎N, 0<x<1), and an aluminum gallium indium nitride layer (AlₓGa_{y}In_{(1-x-y)}N, 0<x<1, 0<x+y<1).

In one embodiment of a manufacturing method of a semiconductor structure of the present invention, the step of providing a plurality of aluminum-containing nitride layers is to provide each of the aluminum-containing nitride layers with an aluminum content, and as the aluminum-containing nitride layers approach the active layer, the aluminum content of each of the aluminum-containing nitride layers increases.

In one embodiment of a manufacturing method of a semiconductor structure of the present invention, the step of providing a plurality of aluminum-containing nitride layers is to provide each of the aluminum-containing nitride layers with an aluminum content, and as the aluminum-containing nitride layers approach the active layer, the aluminum content of each of the aluminum-containing nitride layers decreases.

In one embodiment of a manufacturing method of a semiconductor structure of the present invention, the step of providing a plurality of aluminum-containing nitride layers is to provide each of the aluminum-containing nitride layers with the carbon doping concentration increasing from 1E17~1E19/cm³ as the aluminum-containing nitride layers approach the active layer.

In one embodiment of a manufacturing method of a semiconductor structure of the present invention, the step of providing a silicon barrier composite layer is to provide a plurality of aluminum-containing nitride layers and to iron dope each of the aluminum-containing nitride layers, and as the aluminum-containing nitride layers approach the active layer, an iron doping concentration of each of the aluminum-containing nitride layers increases.

In one embodiment of a manufacturing method of a semiconductor structure of the present invention, the step of providing a nitride buffer composite layer is to provide a first aluminum nitride buffer layer and a second aluminum nitride buffer layer, and the first aluminum nitride buffer layer is disposed above the silicon substrate.

After referring to the drawings and the embodiments as described in the following, those the ordinary skilled in this art can understand other objectives of the present invention, as well as the technical means and embodiments of the present invention.

### BRIEF DESCRIPTION OF THE DRAWINGS

Fig. 1 is a schematic diagram of the semiconductor structure in an embodiment of the present invention;
Fig. 2 is a partially enlarged schematic diagram of the aluminum-containing nitride layer in Fig. 1 of the present invention; and
Fig. 3 is a schematic diagram of the process steps for the semiconductor structure in an embodiment of the present invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application or particular method for implementations described in these embodiments. Therefore, the description of these embodiments is for illustrative purposes only and is not intended to limit the present invention. It shall be appreciated that, in the following embodiments and the attached drawings, a part of elements not directly related to the present invention may be omitted from the illustration, and dimensional proportions among individual elements and the numbers of each element in the accompanying drawings are provided only for ease of understanding but not to limit the present invention.

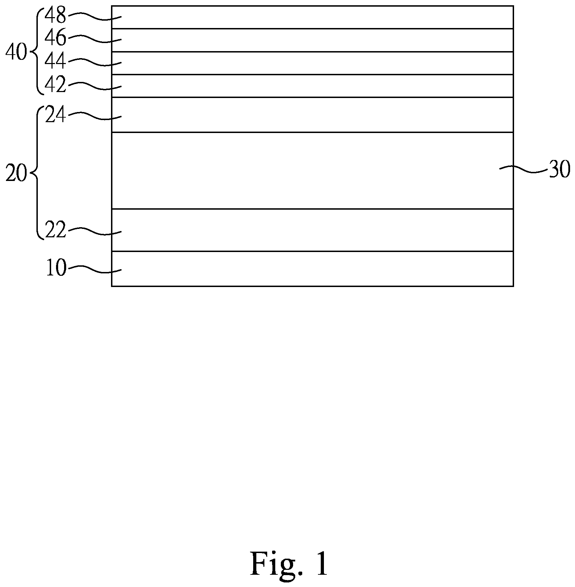

Please refer to Fig. 1, which illustrates a semiconductor structure and its manufacturing method in an embodiment of the present invention, particularly a high electron mobility transistor (HEMT) or a silicon-based nitride semiconductor structure (LED) and its manufacturing method. The following description uses HEMT as an example. First, a silicon substrate 10 is provided. Next, a nitride buffer composite layer 20 is formed on the silicon substrate 10, with a silicon barrier composite layer 30 interposed within the nitride buffer composite layer 20. In this embodiment, the nitride buffer composite layer 20 includes a first aluminum nitride buffer layer 22 and a second aluminum nitride buffer layer 24, with the first aluminum nitride buffer layer 22 disposed above the silicon substrate 10. Finally, an active layer 40 of the device is formed above the nitride buffer composite layer 20. Specifically, the active layer 40, disposed above the second aluminum nitride buffer layer 24, sequentially includes a carbon-doped gallium nitride layer 42, a gallium nitride channel layer 44, an aluminum gallium nitride buffer layer 46, and an undoped gallium nitride cladding layer 48.

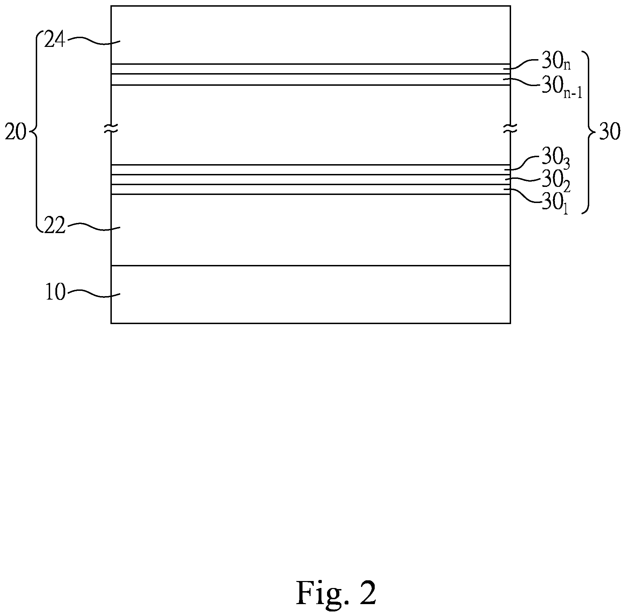

Please refer to Figs. 1 and 2 together, where Fig. 2 presents an enlarged schematic diagram of the silicon barrier composite layer shown in Fig. 1. It should be noted that conventional HEMT devices only have a single aluminum nitride buffer layer, which is insufficient to overcome the lattice defects and tensile stress of the silicon substrate. This limitation makes it difficult to accommodate the lattice mismatch in epitaxial structures which are formed subsequently, leading to poor two-dimensional electron gas characteristics in the device. In view of this, the present invention introduces a silicon barrier compound semiconductor layer interposed within the aluminum nitride buffer layer for increasing compressive strain, blocking the diffusion of silicon impurities from the silicon substrate, and reducing leakage current paths.

As shown in Fig. 2, the silicon barrier composite layer 30, sandwiched between the first aluminum nitride buffer layer 22 and the second aluminum nitride buffer layer 24, comprises a plurality of aluminum-containing nitride layers 30₁, 30₂, 30₃...30ₙ₋₁, 30ₙ. These aluminum-containing nitride layers are alternately stacked using thin film deposition techniques, such as metal-organic chemical vapor deposition (MOCVD) or molecular beam epitaxy (MBE). Specifically, these deposition techniques utilize materials such as trimethylgallium (TMGa), triethylgallium (TEGa), trimethylaluminum (TMAl), trimethylindium (TMIn), and ammonia (NH₃) to form the aluminum-containing nitride layers 30₁, 30₂, 30₃...30ₙ₋₁, 30ₙ. For example, the aluminum-containing nitride layers may be ternary or quaternary compound semiconductor layers, including aluminum gallium nitride (AlₓGa₍₁₋ₓ₎N, 0<x<1), aluminum indium nitride (AlₓIn₍₁₋ₓ₎N, 0<x<1), and aluminum gallium indium nitride (AlₓGa_{y}In_{(1-x-y)}N, 0<x<1, 0<x+y<1). The aluminum content in each layer ranges from 0% to 100%, and the total thickness of the silicon barrier composite layer 30 is less than 3 micrometers (µm). The number of aluminum-containing nitride layers is approximately 150, with each layer having a thickness of less than 500 nanometers (nm). Preferably, each layer has a thickness between 50 and 300 nm. Specifically, when aluminum gallium nitride, aluminum indium nitride, or aluminum gallium indium nitride are used as the material for these layers, the aluminum content can be adjusted layer by layer to ensure lattice matching and stress regulation, which is crucial for mitigating excessive tensile stress in conventional HEMT devices.

There are two methods for adjusting the aluminum content in the aluminum-containing nitride layers 30₁, 30₂, 30₃...30ₙ₋₁, 30ₙ. The first method involves sequentially increasing the aluminum content from bottom to top, making it higher as it approaches the active layer 40. The second method involves sequentially decreasing the aluminum content from bottom to top, making it lower as it approaches the active layer 40. The latter approach is generally preferred, meaning that the aluminum content in the first aluminum-containing nitride layer 30₁ is greater than that in the second aluminum-containing nitride layer 30₂, which is in turn greater than that in the third aluminum-containing nitride layer 30₃, and so on. Following this pattern, the aluminum content in the (n-1)th aluminum-containing nitride layer 30ₙ₋₁ is greater than that in the nth aluminum-containing nitride layer 30ₙ.

On the other hand, conversely, if the aluminum content in the silicon barrier composite layer 30 is sequentially increased from bottom to top, the aluminum content in the silicon barrier layer closer to the active layer 40 will be higher. A high-aluminum-content buffer layer can introduce compressive stress to compensate for the tensile stress caused by thermal expansion differences between the active layer and the silicon substrate, thereby reducing the overall stress in the active layer. However, high aluminum content may lead to wafer warpage due to thermal expansion, which must be addressed. One possible solution is to add a supporting substrate beneath the silicon substrate 10, such as a ceramic substrate or a quartz substrate technology (QST) substrate, to enhance the strength of the silicon substrate 10 and minimize wafer warpage caused by thermal expansion. In other words, under the premise of reinforcing the strength of the silicon substrate 10, increasing the aluminum content in the silicon barrier composite layer 30 layer by layer as it approaches the active layer 40 is also a viable approach for stress regulation to overcome excessive tensile stress in conventional HEMT devices.

Additionally, the aluminum-containing nitride layers 30₁, 30₂, 30₃...30ₙ₋₁, 30ₙ have a carbon doping concentration, which increases as the layers approach the active layer. This feature helps reduce the diffusion of silicon impurities volatilized from the silicon substrate into the upper insulating high-resistance epitaxial layer, thereby enhancing insulation, blocking leakage current paths, and increasing the breakdown voltage of the device. Specifically, carbon doping can be achieved using doping gases such as methane (CH₄), ethylene (C₂H₄), or pentane (C₅H₁₂), or through natural doping within the chamber and diffusion. The carbon doping concentrations for the aluminum-containing nitride layers are as follows: layer 30₁: approximately 1E17~1E19/cm³, layer 30₂: approximately 1E17~1E20/cm³, layer 30₃: approximately 1E17~1E21/cm³, and layer 30₄: approximately 1E17~1E22/cm³. It should be noted that, in addition to carbon doping, iron doping can also be applied to the aluminum-containing nitride layers. Increasing the iron doping concentration in the layers closer to the active layer can also serve to block silicon impurity diffusion from the silicon substrate, enhance insulation, increase the breakdown voltage of the device, and reduce leakage current.

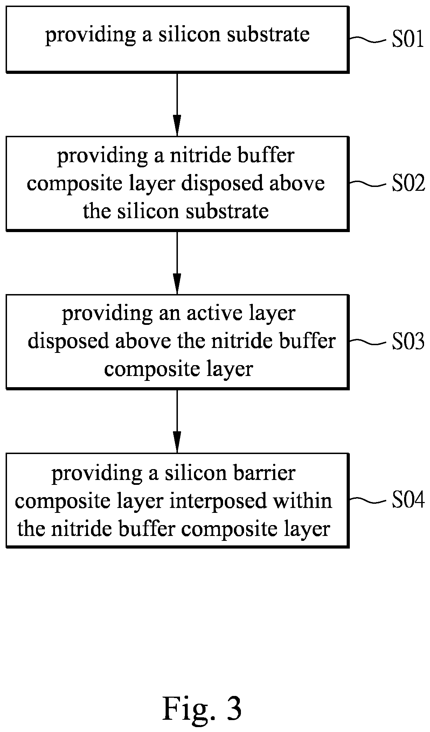

Please refer to Fig. 3, which illustrates the process steps of the semiconductor structure in the present invention. First, in step S01, a silicon substrate is provided. Next, in step S02, a nitride buffer composite layer is formed on the silicon substrate. In step S03, an active layer is provided and formed above the nitride buffer composite layer. In step S04, a silicon barrier composite layer is provided and interposed within the nitride buffer composite layer to effectively block the diffusion of silicon impurities from the silicon substrate, thereby reducing leakage current. The composition and relationships of the components in each process step correspond to the descriptions above and will not be redundantly detailed here.

The above embodiments are used only to illustrate the implementations of the present invention and to explain the technical features of the present invention, and are not used to limit the scope of the present invention. Any modifications or equivalent arrangements that can be easily accomplished by people skilled in the art are considered to fall within the scope of the present invention, and the scope of the present invention should be limited by the claims of the patent application.

## Claims

1. A semiconductor structure, comprising:
a silicon substrate;
a nitride buffer composite layer, disposed above the silicon substrate;
an active layer, disposed above the nitride buffer composite layer; and
a silicon barrier composite layer, interposed within the nitride buffer composite layer to substantially block the diffusion of silicon impurities from the silicon substrate to reduce leakage current.

2. The semiconductor structure of claim 1, wherein the silicon barrier composite layer comprises a plurality of aluminum-containing nitride layers, each of the aluminum-containing nitride layers has a carbon doping concentration, and as the aluminum-containing nitride layers approach the active layer, the carbon doping concentration increases.

3. The semiconductor structure of claim 2, wherein each of the aluminum-containing nitride layers is one of an aluminum gallium nitride layer (AlₓGa₍₁₋ₓ₎N, 0<x<1), an aluminum indium nitride layer (AlₓIn₍₁₋ₓ₎N, 0<x<1), and an aluminum gallium indium nitride layer (AlₓGa_{y}In_{(1-x-y)}N, 0<x<1, 0<x+y<1).

4. The semiconductor structure of claim 2, wherein each of the aluminum-containing nitride layers comprises an aluminum content, and as the aluminum-containing nitride layers approach the active layer, the aluminum content of each of the aluminum-containing nitride layers increases.

5. The semiconductor structure of claim 2, wherein each of the aluminum-containing nitride layers comprises an aluminum content, and as the aluminum-containing nitride layers approach the active layer, the aluminum content of each of the aluminum-containing nitride layers decreases.

6. The semiconductor structure of claim 2, wherein the carbon doping concentration of each of the aluminum-containing nitride layers increases from 1E17~1E19/cm³ as the aluminum-containing nitride layers approach the active layer.

7. The semiconductor structure of claim 2, wherein a thickness of each of the aluminum-containing nitride layers is less than 500 nanometers (nm).

8. The semiconductor structure of claim 1, wherein the silicon barrier composite layer comprises a plurality of aluminum-containing nitride layers, each of the aluminum-containing nitride layers has an iron doping concentration, and as the aluminum-containing nitride layers approach the active layer, the iron doping concentration increases.

9. The semiconductor structure of claim 1, wherein the nitride buffer composite layer comprises a first aluminum nitride buffer layer and a second aluminum nitride buffer layer, and the first aluminum nitride buffer layer is disposed above the silicon substrate.

10. The semiconductor structure of claim 1, wherein the active layer disposed above the nitride buffer composite layer sequentially comprises a carbon doped gallium nitride layer, a gallium nitride channel layer, an aluminum gallium nitride buffer layer and an undoped gallium nitride cladding layer.

11. A manufacturing method of a semiconductor structure, comprising:
providing a silicon substrate;
providing a nitride buffer composite layer, disposed above the silicon substrate;
providing an active layer, disposed above the nitride buffer composite layer; and
providing a silicon barrier composite layer, interposed within the nitride buffer composite layer to substantially block the diffusion of silicon impurities from the silicon substrate to reduce leakage current.

12. The manufacturing method of a semiconductor structure of claim 11, wherein the step of providing a silicon barrier composite layer is to provide a plurality of aluminum-containing nitride layers and to carbon dope each of the aluminum-containing nitride layers, and as the aluminum-containing nitride layers approach the active layer, a carbon doping concentration of each of the aluminum-containing nitride layers increases.

13. The manufacturing method of a semiconductor structure of claim 12, wherein
the step of carbon doping uses one of methane (CH₄), ethylene (C₂H₄), and pentane (C₅H₁₂) as a doping gas for doping, natural doping within a chamber and diffusing, or wherein
the step of providing a plurality of aluminum-containing nitride layers is made by metal organic vapor deposition (MOCVD) process or molecular beam epitaxy (MBE) process using materials including trimethylgallium (TMGa), triethylgallium (TEGa), trimethylaluminum (TMAl), trimethylindium (TMIn) and ammonia (NH₃), or wherein
each of the aluminum-containing nitride layers is one of an aluminum gallium nitride layer (AlₓGa₍₁₋ₓ₎N, 0<x<1), an aluminum indium nitride layer (AlₓIn₍₁₋ₓ₎N, 0<x<1), and an aluminum gallium indium nitride layer (AlₓGa_{y}In_{(1-x-y)}N, 0<x<1, 0<x+y<1).

14. The manufacturing method of a semiconductor structure of claim 12, wherein
the step of providing a plurality of aluminum-containing nitride layers is to provide each of the aluminum-containing nitride layers with an aluminum content, and as the aluminum-containing nitride layers approach the active layer, the aluminum content of each of the aluminum-containing nitride layers increases, or wherein
the step of providing a plurality of aluminum-containing nitride layers is to provide each of the aluminum-containing nitride layers with an aluminum content, and as the aluminum-containing nitride layers approach the active layer, the aluminum content of each of the aluminum-containing nitride layers decreases, or wherein
the step of providing a plurality of aluminum-containing nitride layers is to provide each of the aluminum-containing nitride layers with the carbon doping concentration increasing from 1E17~1E19/cm³ as the aluminum-containing nitride layers approach the active layer.

15. The manufacturing method of a semiconductor structure of claim 11, wherein
the step of providing a silicon barrier composite layer is to provide a plurality of aluminum-containing nitride layers and to iron dope each of the aluminum-containing nitride layers, and as the aluminum-containing nitride layers approach the active layer, an iron doping concentration of each of the aluminum-containing nitride layers increases, or wherein
the step of providing a nitride buffer composite layer is to provide a first aluminum nitride buffer layer and a second aluminum nitride buffer layer, and the first aluminum nitride buffer layer is disposed above the silicon substrate.
